# EUROPEAN PATENT APPLICATION

(11) **EP 4 366 093 A1**
(43) Date of publication of application: **08.05.2024**
(21) Application number: 22882289.6
(22) Date of filing: 25.05.2022
(51) Int. Cl.: H01R 9/26

(54) **PV TERMINAL ASSEMBLY AND ELECTRICAL DEVICE**

(30) Priority: 18.10.2021 CN 202122507851 U
(71) Applicant: Sungrow Power Supply Co., Ltd., Hefei, Anhui 230088 (CN)
(72) Inventor: SHEN, Zhanliang, Hefei, Anhui 230088 (CN); YU, Yanfei, Hefei, Anhui 230088 (CN); CHEN, Peng, Hefei, Anhui 230088 (CN); LI, Xiaoxun, Hefei, Anhui 230088 (CN)
(74) Representative: Rooney, John-Paul
(86) International application number: PCT/CN2022/094952
(87) International publication number: WO 2023/065664

(57) **Abstract**

Disclosed in the present invention are a PV terminal assembly and an electrical device. The PV terminal assembly comprises a mounting frame and at least one PV terminal; the mounting frame is provided with mounting positions used for fixing PV terminals, and there are at least two mounting positions. In the PV terminal assembly disclosed in the present invention, the mounting frame is provided with mounting positions used for fixing PV terminals, and there are at least two mounting positions, so that at least two PV terminals can be integrated on the mounting frame. The number of PV terminals on the whole PV terminal assembly can be adjusted by adjusting the number of PV terminals on the mounting frame; thus, the expandability and compatibility are improved, the whole electrical device can be compatible with a variety of input configurations, and the development efficiency is improved. Moreover, the space occupied by all the PV terminals can be reduced, thereby reducing the size of the whole electrical device; installation of the PV terminals is also simplified, thereby improving the installation efficiency.

## Description

This application claims priority to Chinese Patent Application No. 202122507851.3, titled "PV TERMINAL ASSEMBLY AND ELECTRICAL DEVICE", filed with the China National Intellectual Property Administration on October 18, 2021, which is incorporated herein by reference in its entirety.

### FIELD

The present application relates to the technical field of photovoltaic power generation, and in particular to a PV terminal assembly and an electrical device.

### BACKGROUND

In the field of photovoltaic power generation, an electrical device such as an inverter and a combiner box mainly includes: a cabinet, PV terminals, a current detection board, a direct current switch, a printed circuit board and the like, where PV cables are connected to the PV terminals, the PV terminals are connected to the current detection board through the cable, the current detection board is connected to one side of the direct current switch through the cable, and the other side of the direct current switch is connected to the printed circuit board through the cable.

In the above-mentioned electrical device, a side plate of the cabinet is provided with fixing holes for mounting the PV terminals, and the above-mentioned PV terminals are mounted in the fixing holes from outside of the cabinet. The fixing holes correspond to the PV terminals respectively, and the number of channels of the PV terminals is settled and unadjustable, resulting in poor extensibility and compatibility of the PV terminals, and smaller application scope of the whole electrical device.

In addition, each of the PV terminals is hermetically connected with the cabinet, and generally the PV terminals are hermetically connected with the cabinet through sealing members. In order to ensure a successful mounting of each of the PV terminals, a distance between two adjacent fixing holes is large. Therefore, a space occupied by all of the PV terminals is large, and a volume of the whole electrical device is large.

In summary, the technical problem to be solved by those skilled in the art is to design a PV terminal in such a way that the number of channels of the PV terminals is adjustable and thus the extensibility and compatibility are improved.

### SUMMARY

In view of this, an object of the present application is to provide a PV terminal assembly, so that the number of channels of PV terminals is adjustable, and thus the extensibility and compatibility are improved. Another object of the present application is to provide an electrical device including the PV terminal assembly as described above.

In order to achieve the above objects, the following technical solutions are provided according to the present application.

A PV terminal assembly includes a mounting frame and at least one PV terminal, where the mounting frame is provided with at least two mounting positions used for fixing the at least one PV terminal.

In an embodiment, the mounting frame is in a strip shape, and any two of the mounting positions are sequentially distributed along a length direction of the mounting frame.

In an embodiment, the PV terminal is detachably fixed to the mounting frame.

In an embodiment, the mounting frame is a guide rail, and the PV terminal clips on the guide rail;
or, the mounting frame is a structural member with a mounting hole, and the PV terminal is fixed to the mounting hole through a fastener.

In an embodiment, a PV input port of the PV terminal is a positive PV input port or a negative PV input port, and the number of the PV terminals is even, where at least one of the PV terminals is a positive PV terminal, and at least one of the PV terminals is a negative PV terminal;
the positive PV terminals and the negative PV terminals are alternately distributed; or the positive PV terminals are distributed at one end of the mounting frame, and the negative PV terminals are distributed at the other end of the mounting frame.

In an embodiment, the PV input port of the PV terminal includes a positive PV input port and a negative PV input port.

In an embodiment, the PV terminal is integrated with a sensor, and the PV terminal is provided with a sensor signal output port configured for outputting signals collected by the sensor;
where the PV terminal is provided with a power input port which is configured for inputting a power supply for supplying power to the sensor; or, the PV terminal is integrated with a power supply circuit which is configured for introducing power from a PV input cable connected to the PV terminal and supplying the power to the sensor.

In an embodiment, the PV terminal is integrated with a terminal-dedicated printed circuit board;
in a case that the PV terminal is provided with the power input port, the terminal-dedicated printed circuit board carries the sensor; and
in a case that the PV terminal is integrated with the power supply circuit, the terminal-dedicated printed circuit board carries the sensor and the power supply circuit.

In an embodiment, the sensor includes a temperature sensor and/or a current sensor and/or a voltage sensor.

In the PV terminal assembly provided according to the present application, the mounting frame is provided with at least two mounting positions used for fixing the PV terminals, so that at least two PV terminals are integrated on the mounting frame. The number of channels of PV terminals of the whole PV terminal assembly can be adjusted by adjusting the number of PV terminals on the mounting frame, thereby improving the extensibility and compatibility, enabling the whole electrical device to be compatible with various input configurations, and improving the development efficiency.

Besides, at least two PV terminals can be integrated on the mounting frame of the PV terminal assembly provided by the present application. In the actual use process, compared with the conventional technology in which each of the PV terminals is separately fixed on the cabinet, the mounting frame disclosed herein is directly fixed on the cabinet, which can reduce the space occupied by all of the PV terminals, thereby reducing the volume of the whole electrical device. Further, the mounting of the PV terminal is simplified and the mounting efficiency is improved.

Based on the PV terminal assembly provided above, an electrical device is further provided according to the present application, which includes the PV terminal assembly as described above.

In an embodiment, the electrical device further includes a cabinet and electronic components fixed in the cabinet, where the mounting frame is fixed to the cabinet or the electronic components.

In an embodiment, the cabinet is provided with a via hole for exposing the PV input port of the PV terminal to outside, and the PV terminal assembly is hermetically connected with the via hole.

In an embodiment, the cabinet is provided with a via hole for exposing the PV input port of the PV terminal to outside; and
the electrical device further includes a protective cover which is located outside the cabinet and covers the via hole, and the protective cover is hermetically connected with the cabinet and is provided with a wire leading hole for inserting the PV input cable.

In an embodiment, the protective cover is provided with a waterproof ring fixed to the wire leading hole, and the waterproof ring is configured for hermetically connecting the wire leading hole and the PV input cable.

In an embodiment, the wire leading hole is sealed by the waterproof ring, and the waterproof ring is puncturable, so that the PV input cable can puncture and pass through the waterproof ring.

### BRIEF DESCRIPTION OF THE DRAWINGS

For more clearly illustrating embodiments of the present application or technical solutions in the conventional technology, the drawings referred to for describing the embodiments or the conventional technology will be briefly described hereinafter. Apparently, the drawings in the following description are only some examples of the present application, and for those skilled in the art, other drawings may be obtained based on the provided drawings without any creative efforts.
FIG. 1 is a schematic structural view of a PV terminal assembly according to an embodiment of the present application;
FIG. 2 is a side view of the PV terminal assembly according to an embodiment of the present application;
FIG. 3 is a top view of the PV terminal assembly according to an embodiment of the present application;
FIG. 4 is a view showing a distribution of PV terminals of the PV terminal assembly according to an embodiment of the present application;
FIG. 5 is a view showing another distribution of PV terminals of the PV terminal assembly according to an embodiment of the present application;
FIG. 6 is a view showing another distribution of PV terminals of the PV terminal assembly according to an embodiment of the present application;
FIG. 7 is a schematic structural view of an electrical device according to an embodiment of the present application;
FIG. 8 is a partial enlarged view of FIG. 7;
FIG. 9 is a side view of an electrical device according to an embodiment of the present application;
FIG. 10 is a cross-sectional view of FIG. 9, taken along line A-A; and
FIG. 11 is a partial enlarged view of FIG. 10.

### DETAILED DESCRIPTION OF THE EMBODIMENTS

The technical solutions according to the embodiments of the present application will be described clearly and completely as follows in conjunction with the drawings in the embodiments of the present application. It is apparent that the described embodiments are only some of the embodiments according to the present application, rather than all the embodiments. Based on the embodiments in the present application, any other embodiments obtained by those skilled in the art without any creative efforts fall within the protection scope of the present application.

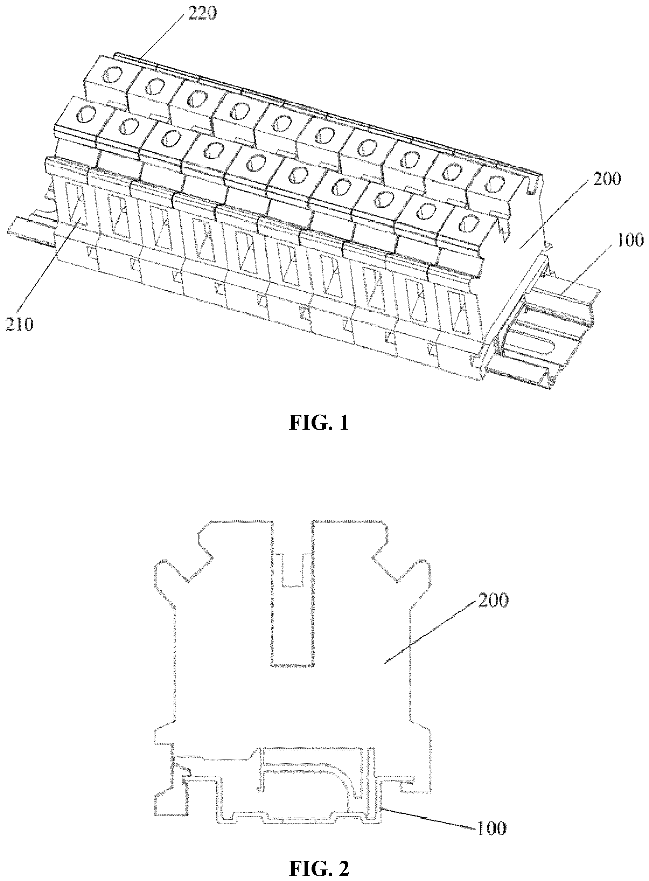

As shown in FIG. 1 to FIG. 6, a PV terminal assembly provided according to an embodiment of the present application includes a mounting frame 100 and at least one PV terminal 200. The mounting frame 100 is provided with at least two mounting positions used for fixing the at least one PV terminal 200.

It should be noted that one mounting position is used for mounting one PV terminal 200, that is, the mounting position is in one-to-one correspondence with the PV terminal 200. The number of the above-mentioned PV terminals 200 may be selected based on actual needs, that is, it is applicable that all of the mounting positions are fixed with the PV terminals 200, and it is also applicable that only some of the mounting positions are fixed with the PV terminals 200, and the rest mounting positions are vacant of the PV terminals 200.

In the PV terminal assembly provided according to the above embodiment, the mounting frame 100 is provided with at least two mounting positions used for fixing the PV terminals 200, so that at least two PV terminals 200 are integrated on the mounting frame 100. The number of channels of the whole PV terminal assembly can be adjusted by adjusting the number of PV terminals 200 on the mounting frame 100, thereby improving the extensibility and compatibility, enabling the whole electrical device to be compatible with various input configurations, and improving the development efficiency.

Besides, in the PV terminal assembly provided according to the above embodiment, at least two PV terminals 200 can be integrated on the mounting frame 100. In the actual use process, compared with the conventional technology in which each of the PV terminals is separately fixed on the cabinet, the mounting frame 100 herein is directly fixed on a cabinet 300, which can reduce the space occupied by all of the PV terminals 200, thereby reducing the volume of the whole electrical device. Further, the mounting of the PV terminal 200 is simplified and the mounting efficiency is improved.

In a case that the number of the PV terminal 200 is at least two, two adjacent PV terminals 200 are in contact with each other, so as to minimize the space occupied by the PV terminal assembly.

In practices, a gap may be provided between two adjacent PV terminals 200, and a size of the gap is selected based on actual needs, which is not limited in this embodiment. Also, a spacer may be arranged between two adjacent PV terminals 200, and the spacer is fixed to the mounting frame 100. The PV terminal 200 may be in contact with the spacer or there is a gap between the PV terminal 200 and the spacer, which depends on actual needs and is not limited in this embodiment.

The shape of the mounting frame 100 is selected based on actual needs. Optionally, the mounting frame 100 is in a strip shape, and any two of the mounting positions are sequentially distributed along a length direction of the mounting frame 100. It can be understood that if the number of the PV terminals 200 on the mounting frame 100 is at least two, any two of the PV terminals 200 are sequentially distributed along the length direction of the mounting frame 100.

In particular, the mounting frame 100 is rectangular. In practices, the mounting frame 100 may also be in other shapes, such as square and the like, which is not limited in this embodiment.

In order to further improve the extensibility and compatibility, the PV terminal 200 is detachably fixed to the mounting frame 100. In this way, the number of the PV terminals 200 on the mounting frame 100 is adjustable at will, which increases an adjustment range.

In practices, the PV terminal 200 may be detachably fixed to the mounting frame 100 through a threaded connector, or the PV terminal 200 may be detachably fixed to the mounting frame 100 through a clip-on structure, which is selected based on actual needs.

In particular, in a case that the mounting frame 100 is a guide rail, the PV terminal 200 may clip on the guide rail 100. In a case that the mounting frame 100 is a structural member with a mounting hole, the PV terminal 200 may be fixed to the mounting hole by a fastener. It can be understood that the PV terminal 200 may be detachably fixed to the mounting hole by a fastener.

In the above-mentioned PV terminal assembly, the specific structure of the PV terminal 200 is selected based on actual needs. In particular, the PV terminal 200 has a PV input port 210 and a PV output port 220. A PV input cable 500 is connected to the PV input port 210. For the convenience of mounting, a connection end of the PV input cable 500 is provided with a PV pin, and the PV pin is connected with the PV input port 210.

Optionally, the PV input port 210 of the PV terminal 200 is a positive PV input port 210a or a negative PV input port 210b. In this case, the number of the PV terminals 200 is even, where at least one of the PV terminals 200 is a positive PV terminal 200a, and at least one of the PV terminals 200 is a negative PV terminal 200b.

It can be understood that the PV input port 210 of the positive PV terminal 200a is the positive PV input port 210a, and the PV input port 210 of the negative PV terminal 200b is the negative PV input port 210b.

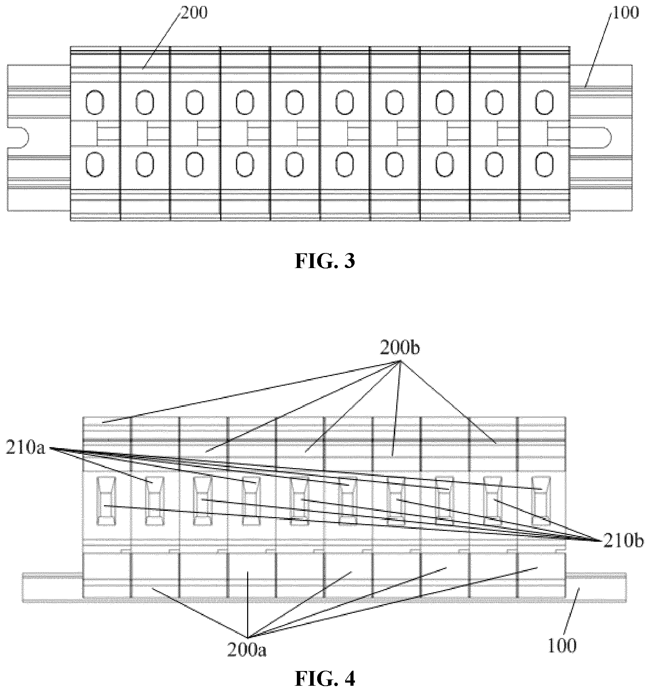

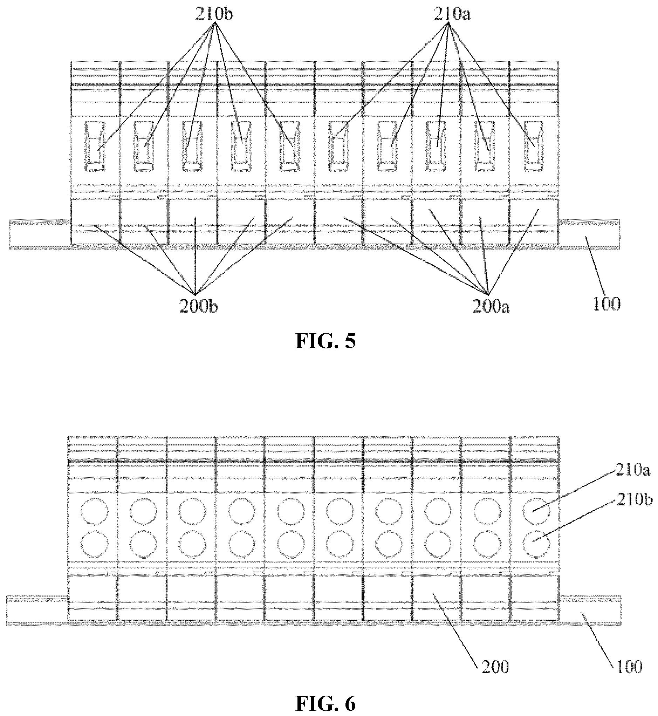

In the above-mentioned PV terminals 200, the positive PV terminals 200a and the negative PV terminals 200b are alternately distributed, as shown in FIG. 4. Alternatively, the positive PV terminals 200a are distributed at one end of the mounting frame 100, and the negative PV terminals 200b are distributed at the other end of the mounting frame 100, as shown in FIG. 5. Alternatively, the positive PV terminals 200a and the negative PV terminals 200b are distributed in other ways, which is not limited in this embodiment.

Among the above-mentioned PV terminals 200, in a case that the positive PV terminals 200a are distributed at one end of the mounting frame 100 and the negative PV terminals 200b are distributed at the other end of the mounting frame 100, adjacent positive PV terminals 200a and negative PV terminals 200b may be in contact with each other, or a gap is arranged between adjacent positive PV terminals 200a and negative PV terminals 200b. It can be understood that the positive PV terminals 200a and the negative PV terminals 200b are distributed in the same direction. For the convenience of connection, the positive PV terminals 200a and the negative PV terminals 200b may be distributed in a same row.

In practices, the PV input port 210 of the PV terminal 200 may include a positive PV input port 210a and a negative PV input port 210b, as shown in FIG. 6. Optionally, in each of the PV terminals 200, the positive PV input port 210a and the negative PV input port 210b may be sequentially distributed along a height direction of the PV terminal 200, as shown in FIG. 6. Alternatively, in each of the PV terminals 200, the positive PV input port 210a and the negative PV input port 210b may be sequentially distributed along a width direction of the PV terminal 200.

It can be understood that the positive PV input port 210a and the negative PV input port 210b are located at the same side of the PV terminal 200.

In the electrical device, it is generally required to collect required signals, such as temperature signals, current signals and voltage signals. In order to simplify the structure, the PV terminal 200 may be integrated with a sensor, and the PV terminal 200 is provided with a sensor signal output port configured for outputting signals collected by the sensor.

In order to ensure the power supply to the sensor, the PV terminal 200 may be provided with a power input port which is configured for inputting a power supply for supplying power to the sensor. It can be understood that the power input port is connected with the sensor. For the convenience of wiring, the power input port and the PV input port 210 are located at the same side of the PV terminal 200.

In practices, the PV terminal 200 may be integrated with a power supply circuit which is configured for introducing power from the PV input cable 500 connected to the PV terminal 200 and supplying the power to the sensor.

For the PV terminal assembly described above, in order to facilitate the assembly of the sensor and the power supply circuit, the PV terminal 200 may be integrated with a terminal-dedicated printed circuit board. In a case that the PV terminal 200 is provided with the power input port, the terminal-dedicated printed circuit board carries the sensor. In a case that the PV terminal 200 is integrated with the power supply circuit, the terminal-dedicated printed circuit board carries the sensor and the power supply circuit.

A type of the above sensor is selected based on actual needs. For example, the sensor as described above may be a temperature sensor and/or a current sensor and/or a voltage sensor, which is not limited in this embodiment.

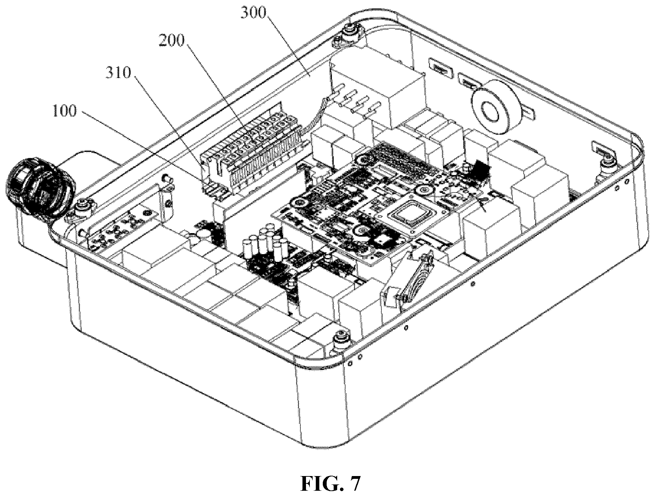

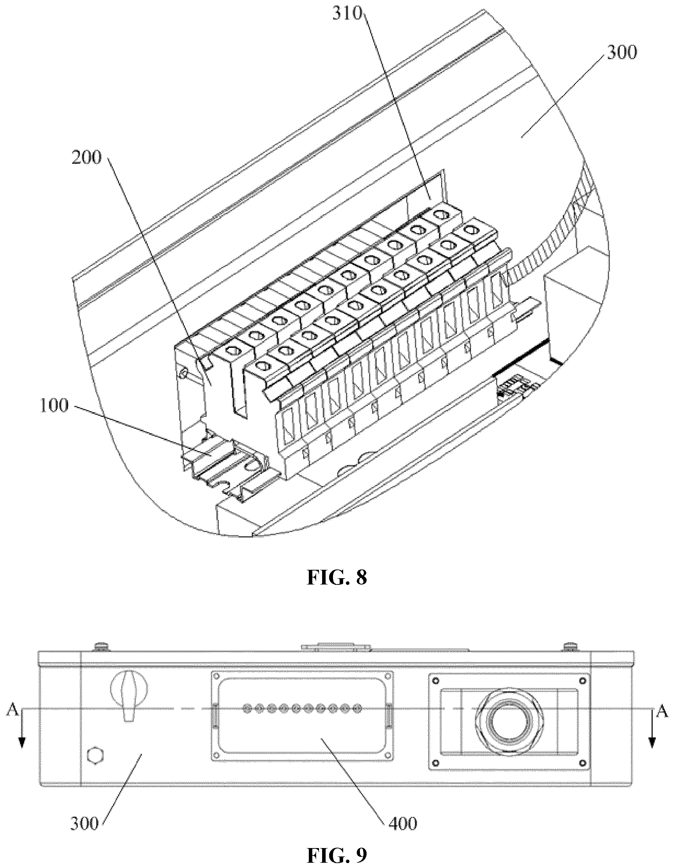

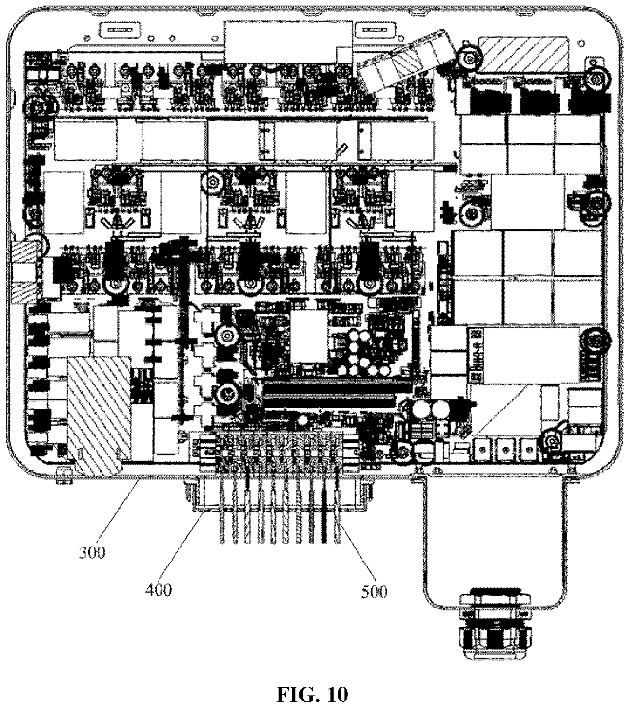

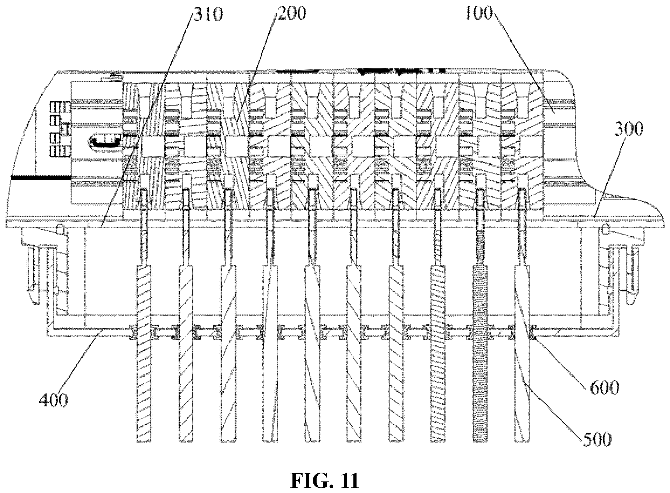

Based on the PV terminal assembly provided in the above embodiments, an electrical device is further provided according to this embodiment, as shown in FIG. 7 to FIG. 11, which includes the PV terminal assembly as described in the above embodiments.

Since the PV terminal assembly according to above embodiments has the above technical effects, and the above electrical device includes the PV terminal assembly as described above, the above electrical device also has corresponding technical effects, which will not be described in detail here.

The above electric device includes a cabinet 300 and electronic components fixed in the cabinet 300. The mounting frame 100 is fixed to the cabinet 300 or the electronic components. In particular, the mounting frame 100 may penetrate through a side plate of the cabinet 300, or the mounting frame 100 may be located inside the cabinet 300, which is selected based on actual needs.

The above electronic components may be printed circuit boards or current detection boards, which is selected based on actual needs and not limited in this embodiment.

In order to ensure wiring, the cabinet 300 is provided with a via hole 310 which allows the PV input port 210 of the PV terminal 200 to be exposed to outside. In order to ensure the protection requirements, the PV terminal assembly may be hermetically connected with the via hole 310. Alternatively, the electrical device may further include a protective cover 400 which is located outside the cabinet 300 and covers the via hole 310. The protective cover 400 is hermetically connected with the cabinet 300 and is provided with a wire leading hole for inserting the PV input cable 500.

In practices, in order to facilitate sealing, the electrical device may include the protective cover 400 as described above. In order to simplify the structure, the number of the via hole 310 may be one, that is, the PV input ports 210 of all of the PV terminals 200 can be exposed to outside with only one via hole 310.

In order to facilitate the sealing of the PV input cable 500 and the wire leading hole, the protective cover 400 is provided with a waterproof ring 600 fixed to the wire leading hole, and the waterproof ring 600 is configured for hermetically connecting the wire leading hole and the PV input cable 500.

The waterproof ring 600 may be any type of waterproof ring as required. In order to facilitate the sealing and wiring, the wire leading hole is sealed by the waterproof ring 600, and the waterproof ring 600 is puncturable, so that the PV input cable 500 can puncture and pass through the waterproof ring. In particular, when the PV input cable 500 is not mounted, the waterproof ring 600 seals the wire leading hole, and when the PV input cable 500 needs to be mounted, the PV input cable 500 can penetrate through the waterproof ring 600 and pass through the waterproof ring 600. In this way, when the PV input cable 500 does not need to be mounted, there is no need for additional parts to seal the wire leading hole, which reduces the number of components, simplifies the structure and reduces the cost.

In practices, the waterproof ring 600 may only be used for sealingly connecting the wire leading hole and the PV input cable 500, and other parts may be used to seal the wire leading hole separately, which is not limited to the above embodiment.

Based on the above description of the disclosed embodiments, the present application can be implemented or used by those skilled in the art. Various modifications to these embodiments are apparent to those skilled in the art, and the general principle defined herein may be implemented in other embodiments without departing from the spirit or scope of the present application. Hence, the present application is not limited to the embodiments disclosed herein, but shall conform to the widest scope in accordance with the principle and novel features disclosed herein.

## Claims

1. A PV terminal assembly, comprising a mounting frame (100) and at least one PV terminal (200), wherein the mounting frame (100) is provided with at least two mounting positions used for fixing the at least one PV terminal (200).

2. The PV terminal assembly according to claim 1, wherein the mounting frame (100) is in a strip shape, and any two of the mounting positions are sequentially distributed along a length direction of the mounting frame (100).

3. The PV terminal assembly according to claim 1, wherein the at least one PV terminal (200) is detachably fixed to the mounting frame (100).

4. The PV terminal assembly according to claim 1, wherein
the mounting frame (100) is a guide rail, and the at least one PV terminal (200) clips on the guide rail (100); or,
the mounting frame (100) is a structural member with a mounting hole, and the at least one PV terminal (200) is fixed to the mounting hole through a fastener.

5. The PV terminal assembly according to claim 1, wherein
a PV input port (210) of each PV terminal (200) is a positive PV input port (210a) or a negative PV input port (210b), and the number of the at least one PV terminal (200) is even, wherein at least one of the PV terminals (200) is a positive PV terminal (200a), and at least one of the PV terminals (200) is a negative PV terminal (200b);
the at least one positive PV terminal (200a) and the at least one negative PV terminal (200b) are alternately distributed; or the at least one positive PV terminal (200a) is distributed at one end of the mounting frame (100), and the at least one negative PV terminal (200b) is distributed at the other end of the mounting frame (100).

6. The PV terminal assembly according to claim 1, wherein a PV input port (210) of each PV terminal (200) comprises a positive PV input port (210a) and a negative PV input port (210b).

7. The PV terminal assembly according to any one of claims 1 to 6, wherein
the PV terminal (200) is integrated with a sensor, and the PV terminal (200) is provided with a sensor signal output port configured for outputting signals collected by the sensor;
wherein the PV terminal (200) is provided with a power input port which is configured for inputting a power supply for supplying power to the sensor; or, the PV terminal (200) is integrated with a power supply circuit which is configured for introducing power from a PV input cable (500) connected to the PV terminal (200) and supplying the power to the sensor.

8. The PV terminal assembly according to claim 7, wherein the PV terminal (200) is integrated with a terminal-dedicated printed circuit board;
in a case that the PV terminal (200) is provided with the power input port, the terminal-dedicated printed circuit board carries the sensor; and
in a case that the PV terminal (200) is integrated with the power supply circuit, the terminal-dedicated printed circuit board carries the sensor and the power supply circuit.

9. The PV terminal assembly according to claim 7, wherein the sensor comprises: a temperature sensor and/or a current sensor and/or a voltage sensor.

10. An electrical device, comprising the PV terminal assembly according to any one of claims 1 to 9.

11. The electric device according to claim 10, further comprising: a cabinet (300) and electronic components fixed in the cabinet (300), wherein the mounting frame (100) is fixed to the cabinet (300) or the electronic components.

12. The electrical device according to claim 11, wherein the cabinet (300) is provided with a via hole (310) for exposing the PV input port (210) of the PV terminal (200) to outside, and the PV terminal assembly is hermetically connected with the via hole (310).

13. The electrical device according to claim 11, wherein
the cabinet (300) is provided with a via hole (310) for exposing the PV input port (210) of the PV terminal (200) to outside; and
the electrical device further comprises a protective cover (400) which is located outside the cabinet (300) and covers the via hole (310), and the protective cover (400) is hermetically connected with the cabinet (300) and is provided with a wire leading hole for inserting the PV input cable (500).

14. The electrical device according to claim 13, wherein the protective cover (400) is provided with a waterproof ring (600) fixed to the wire leading hole, and the waterproof ring (600) is configured for hermetically connecting the wire leading hole and the PV input cable (500).

15. The electrical device according to claim 14, wherein the wire leading hole is sealed by the waterproof ring (600), and the waterproof ring (600) is puncturable, so that the PV input cable (500) can puncture and pass through the waterproof ring (600).
